# EUROPEAN PATENT APPLICATION

(11) **EP 0 601 650 A1**
(43) Date of publication of application: **15.06.1994**
(21) Application number: 93203396.2
(22) Date of filing: 03.12.1993
(51) Int. Cl.: G09G 3/36, G06F 11/20

(54) **Repairable matrix display**

(30) Priority: 10.12.1992 US 988629
(71) Applicant: Philips Electronics N.V., 5621 BA Eindhoven (NL)
(72) Inventor: Carlson, Allan, NL-5656 AA Eindhoven (NL)
(74) Representative: Houbiers, Ernest Emile Marie Gerlach

(57) **Abstract**

A matrix display apparatus includes an addressing circuit for addressing pixels of the display by means of row-address conductors. The addressing circuit includes a shift register having successive stages coupled to the pixels through respective buffer devices which are electrically connected in the row-address conductors. In order to circumvent defects which would prevent a timing pulse from propagating through individual stages of the shift register, a number of spare shift-register stages are distributed along the length of the shift register. The spare stages can be connected in place of defective stages of the shift register via a pair of reparative conductors which insulatively cross the row-address conductors. Spare buffer devices are similarly provided.

## Description

A matrix display apparatus comprising a multiplicity of pixels, an array of row and column address conductors which are insulated from each other and which are electrically coupled to ones of the pixels which are spatially associated with places where said row and column address conductors cross each other, and means for addressing the row and column address conductors to enable selective application to the pixels of respective signals representative of an image to be presented by the apparatus.

Currently, the best known matrix display of the above-described type is the liquid crystal display (LCD) which utilizes thin-film transistors (TFTs) to activate associated LCD pixels. Ordinarily, the pixels and their associated TFTs are located at places where transversely-arranged row and column address conductors cross, and specific pixels are selected by addressing the respective intersecting row and column address conductors. For a detailed description of LCD structure and of circuitry for addressing TFT-activated pixels, one may refer to texts such as E. Kaneko, Liquid Crystal TV Displays, D. Reidel Publishing Company, Kluwer Academic Publishers Group, 1987.

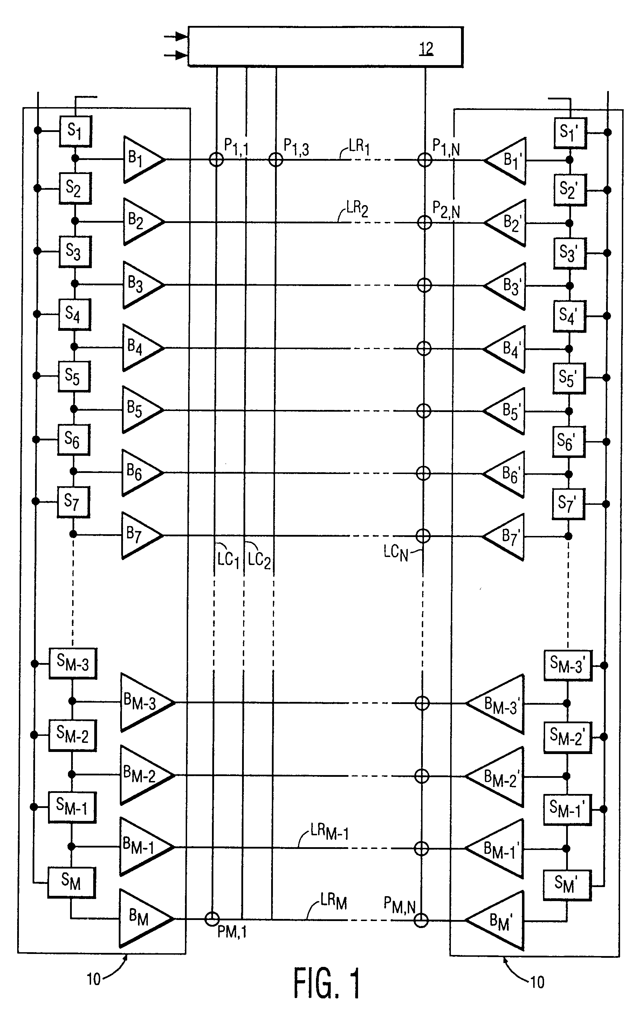

Because of the complexity of matrix arrangements of pixels, associated TFTs, row and column address conductors, and the circuitry needed to address the pixels, it is desirable to fabricate as much of the arrangement as possible by thin-film technology on a substrate of the LCD panel itself. Because of the high cost of such highly-integrated arrangements, it is important to maximize yield. One approach for maximizing yield is to incorporate in the matrix arrangements duplicate or redundant circuitry for simultaneously addressing the row/column address conductors from both ends. This approach is ineffective, however, in overcoming certain types of defects, as will be explained with reference to Figure 1.

Figure 1 illustrates a known liquid crystal display apparatus which includes redundant row-addressing circuitry. The display apparatus includes a multiplicity of pixels (and their associated TFTs) which are each identified by a respective designation P_{m,n}, where m and n identify the specific row and column address conductors over which each pixel is addressed. The row and column address conductors are designated LR₁, LR₂, ... LR_{M} and LC₁, LC₂, LC₃, ... LC_{N}, respectively. The redundant row-addressing circuitry includes duplicate circuits 10 and 10', each of which has an input for receiving row clock pulses, an input for receiving periodic start pulses, and a multiplicity of outputs electrically connected to respective row address conductors. The display apparatus also includes a column-addressing circuit 12 having a first input for receiving column timing pulses, a second input for receiving an image signal, and a multiplicity of outputs electrically connected to respective column address conductors.

A typical use for a LCD apparatus is projecting or directly displaying a television image. For such a use, the image signal is derived from the video signal, while the column timing pulses, the row clock pulses, and the start pulses are derived from the vertical and horizontal synch pulses. The image signal has a time-varying voltage which is to be continually sampled and applied over the column address conductors to sequentially-addressed pixels of the display. In some systems, a line of video information is stored in a line memory to enable simultaneous (parallel) addressing of the column address conductors.

Row-addressing circuit 10 includes an M-stage shift register, having stages S₁, S₂, ... S_{M}, and M output buffer devices B₁, B₂, ... B_{M} electrically connected in openings in the row address conductors LR₁, LR₂, ... LR_{M} to couple the outputs of respective shift register stages to the pixels. The output of each stage Sₘ is electrically connected to the input of a successive stage Sₘ₊₁ so that a logical ONE can be continually propagated through the shift register under the control of the row-clock pulses. As the logical ONE propagates through the shift register, it appears successively at the inputs of the buffer devices B₁, B₂, ... B_{M} and successively addresses the rows of pixels located along the respective row address conductors. More precisely, as the voltage level corresponding to a logical ONE appears at the output of each shift register stage, it causes the connected buffer device to produce a predetermined output voltage which will switch ON the TFTs associated with the pixels in the selected row.

Column-addressing circuit 12 functions similarly to row-addressing circuit 10. However, in addition to addressing the column address conductors LC₁, LC₂, ... LC_{N}, it supplies to these conductors data signals representative of samples of the image signal. Specifically, while any row of pixels is addressed by circuit 10, the column-addressing circuit applies to the column address conductors for these pixels, data signals representative of brightnesses, e.g. gray levels, corresponding to the segments of the image to be displayed by these pixels. A specific column-addressing circuit will not be described, because it is not needed for an understanding of the invention. Many varieties of such data-supplying, column-addressing circuits are known.

Row-addressing circuit 10' is a duplicate of row-addressing circuit 10 and receives the same row clock signal. This duplicate circuit is provided to ensure that each row address conductor is addressed at the appropriate time, even if row-addressing circuit 10 has a defect which prevents it from addressing one or more row address conductors. Ideally, the duplicate row-addressing circuit would provide complete redundancy, so that there will be no deterioration of the image displayed by the pixels even if row-addressing circuit 10 fails completely. Unfortunately, however, this is often not the result.

There are two general categories of defects which cannot be cured by the duplicate row-addressing circuit. First, if the duplicate circuit is itself imperfect, such that a defect exists in both circuit 10 and circuit 10', at least one complete row of pixels can be adversely affected. In fact, many rows could be made completely inoperable by only one defect in each of the two row-addressing circuits. For example, if a defect in shift register stage S₃ prevents the appearance at its output of the propagating logical ONE, neither this stage nor any following stage will be able to address its respective row of pixels. Row address conductors LR₃ through LR_{M} will be addressable only by duplicate row-addressing circuit 10'. However, if the duplicate circuit has a defect in its shift register stage S₄' which similarly stops the propagation of the logical ONE in the duplicate shift register, the last addressable row of pixels in the display will be those in row 3. All subsequent rows of pixels will be inoperable.

The second general category of defects which cannot be cured by the duplicate row-addressing circuit relates to buffer devices which become locked in a low-output-impedance mode. This can happen, for example, to any buffer device which has a CMOS output inverter. It can be caused by a defect in the device itself or in a shift register stage to which its input is electrically connected. The low impedance will provide a path from the row address conductor connected to the output of the buffer device to one of the supply voltages for the buffer device. This could load down the output of the buffer device at the opposite end of the respective row address conductor and make some or all of the pixels in the row inoperable.

It is an object of the invention to provide a matrix display having addressing circuitry which includes repair means for circumventing defects in the circuitry.

It is another object of the invention to provide repair means which effectively increases the yield of matrix displays without requiring redundant addressing circuits, but which is usable with such circuits.

A matrix display apparatus in accordance with the invention, is characterized in that the means for addressing the row and column address conductors comprises, at least for a plurality of said address conductors:
a. an addressing circuit comprising a shift register including a plurality of stages having outputs coupled to respective ones of said address conductors;
b. first and second reparative conductors crossing predetermined ones of said plurality of address conductors;
c. at least one spare shift-register stage; and
d. connection means for electrically connecting an input of the at least one spare shift-register stage, via the first reparative conductor, to an output of a selected one of the stages in the shift register, and for electrically connecting an output of the at least one spare shift-register stage, via the second reparative conductor, to an input of a different selected one of the stages in the shift register.

In a preferred embodiment of the invention, the display apparatus includes openable connection means for selectively disconnecting the outputs of predetermined ones of the stages in the shift register from inputs of successive stages. This permits the output of a defective stage to be isolated from the input of a replacement stage.

Figure 1 is a schematic diagram of a prior art liquid crystal display with redundant pixel-addressing means.

Figure 2 is a schematic diagram of a preferred embodiment of a row addressing circuit in accordance with the invention.

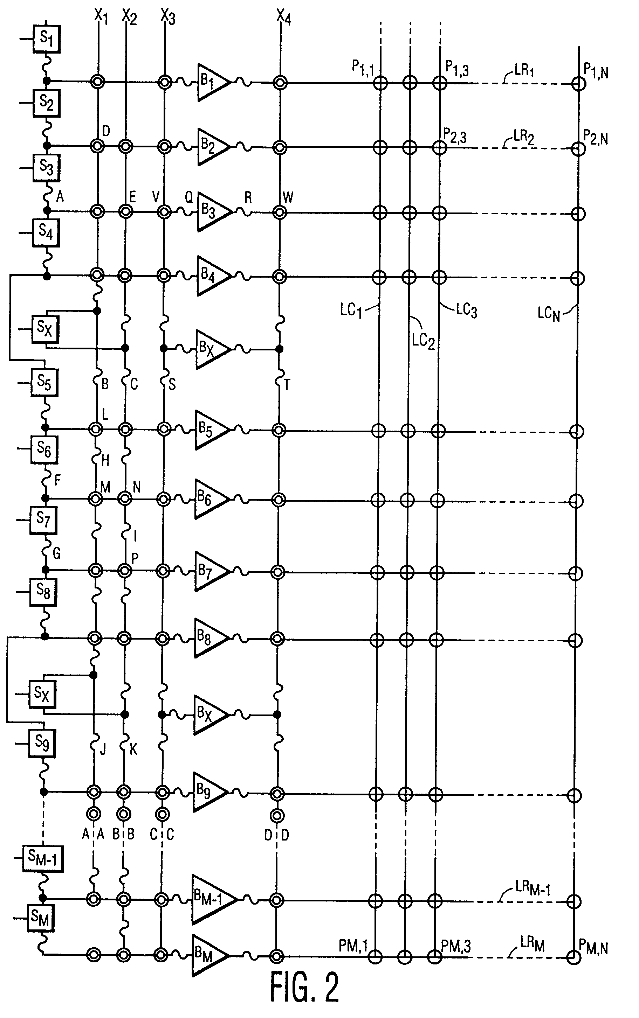

Figure 2 illustrates, in part, an exemplary embodiment of a matrix display having a row-addressing circuit in accordance with the invention. Parts in the apparatus which are substantially identical to corresponding parts in the apparatus of Figure 1 are marked identically. For simplicity, the column-addressing circuit 12 is not shown.

Only a single row-addressing circuit 10 is utilized in the preferred embodiment, because this reduces the cost and the complexity of the display apparatus. However, a redundant row-addressing circuit could also be connected to the row address conductors. Most conveniently, this would be done at the opposite end of the row conductors. Alternatively, a number of addressing circuits could be provided, with each connected to a different group of conductors. For example, in an interlaced or progressive-scan display, a first row-addressing circuit could be connected to odd-numbered row address conductors and a second row-addressing circuit could be connected to even-numbered row address conductors.

Referring to Figure 2, the row-addressing circuit includes the serially-connected shift register stages S₁, S₂, ... S_{N} and
the buffer devices B₁, B₂, ... B_{M} which are connected in the row address conductors LR₁, LR₂, ... LR_{M}, respectively. The row-addressing circuit also includes first and second pairs of reparative conductors X₁,X₂ and X₃,X₄ which run the length of the shift register, crossing the row address conductors LR₁, LR₂, ... LR_{M}. These crossing conductors are made electrically connectable to each other by means of closable connection devices. Each of the closable connection devices is illustrated by a concentric-circle symbol, which represents first and second conductive pads to which the crossing conductors are separately connected.

The conductive pads of each closable connection device are normally separated from each other by an electrical insulator, but can be electrically connected to each other by wire bonding, by applying conductive paint, or by another technique such as laser fusing. The latter technique is particularly applicable if the conductive pads are disposed on opposite sides of an insulating layer and are weldable to each other by focusing a laser beam at the pads and the intervening layer. An example of such a welding technique is described in detail in D. E. Castleberry et al., "A 1 Mega-Pixel Color a-Si TFT Liquid Crystal Display", 1988 SID Digest of Technical Papers, pages 232 - 234, paper 13.1.

In order to circumvent defects which stop propagation or the logical ONE through the shift register in the row-addressing circuit, a number of spare shift-register stages Sₓ are electrically connected to the pair of reparative conductors X₁,X₂ at intervals along the length of the shift register. Each of these spare shift-register stages has its input connected to conductor X₁, has its output connected to conductor X₂, and has a control input which is connected to a bus (not shown) that carries the row clock signal.

Similarly, in order to circumvent defects related to the buffer devices themselves, a number of spare buffer devices Bₓ are electrically connected to the pair of reparative conductors X₃,X₄ at intervals along the length of the shift register. Each of these spare buffer devices has its input connected to conductor X₃ and has its output connected to conductor X₄.

In this exemplary embodiment, a spare shift register stage element Sₓ and a spare buffer device element Bₓ are provided after every fourth stage of the shift register. Many other distributions of these elements are possible, but the probability of being able to repair defects increases with the number of spare stages and buffer devices provided and with their location at strategic positions. For example, if a particular matrix display apparatus is more likely to have defects in specific regions of its addressing circuit(s), the spare elements can be concentrated in these regions rather than evenly distributed along the length of the shift register.

To enable substitution of the spare elements for defective shift-register stages and/or defective buffer devices, a plurality of openable connection devices are strategically located in the conductors which connect the successive stages S₁, S₂, ... S_{M} of the shift register and in the reparative conductors X₁,X₂,X₃,X₄. Each of these devices, which is represented by a wavy-line symbol, is simply a portion of the respective conductor which is disposed in an area of the substrate which facilitates its opening. This could be done, for example, by severing the conductor mechanically, by passing an overcurrent through the portion of the conductor, or by another technique such as vaporizing the portion of the conductor with a laser. To facilitate severance by use of an overcurrent, the openable connection devices could each include a pair of conductive pads between which the portion of conductor to be severed is disposed.

As an example of how the reparative conductors and spare elements could be used to circumvent defects, consider again the case where shift register stage S₃ is defective, preventing the addressing of rows 3 through M by the shift register. (If a duplicate row addressing circuit is connected to the opposite end of the row address conductors, the following discussion applies equally to the repair of the duplicate circuit by the use of the spare elements in that circuit.)

The defect in stage S₃ can be circumvented, making all rows of pixels operable, by opening the connection devices at locations A,B,C and by closing the connection devices at locations D,E. The opened connection device at location A will isolate the output of defective shift register stage S₃ from successive stages in the shift register and from the input of buffer device B₃. The closed connection devices at locations D,E will electrically connect the spare shift-register stage Sₓ which is disposed between stages S₄ and S₅ in place of stage S₃. The opened connection devices at locations B,C will isolate this spare stage from all other spare stages connected to the reparative conductors X₁,X₂, so that they can be used independently in the replacement of any stage following stage S₅.

Note that the above-described replacement of defective stage S₃ would also cure the problem which would occur if the defect in this stage had been forcing the output of the buffer device connected to its output, i.e. B₃, to remain in the logical ONE or the logical ZERO state. If, however, a buffer device itself is defective, the defect can be circumvented by replacing the buffer device with one of the spare devices Bₓ.

As an example of how multiple defects can be circumvented, consider the situation where shift-register stages S₆, S₇ and buffer device B₃ are defective. The defects in the two shift-register stages can be circumvented by opening the connection devices at locations F,G,H,I,J,K and by closing the connection devices at locations L,M,N,P. These opened and closed connections will electrically connect the two spare stages Sₓ shown in Figure 2 in place of the defective stages, will isolate the outputs of the defective stages from successive stages and from the inputs of respective buffer devices B₆, B₇ while connecting these inputs to the outputs of the spare stages, and will isolate the spare stages which are used from the other spare stages (not shown) which are electrically connected to the reparative conductors X₁,X₂.

The defect in buffer device B₃ can be circumvented by opening the connection devices at locations Q,R,S,T and by closing the connection devices at locations V,W. These opened and closed connections will electrically connect the spare buffer device Bₓ which is disposed between buffer devices B₄ and B₅ in place of defective buffer device B₃, will isolate the defective buffer device from shift-register stage S₃ and row address conductor LR₃, and will isolate this spare buffer device from all other spare buffer devices connected to the reparative conductors X₃,X₄. If the input impedance of the defective buffer device remains at a high impedance, it is not necessary to open the connection device at location Q.

Note that the row-addressing circuit may also include a number of closable connection devices distributed along the length of the reparative conductors. One set of such devices is illustrated at locations AA,BB,CC,DD. These devices, which are normally open, facilitate probing of the reparative conductors to determine where defects exist in the row-addressing circuitry. They can be closed as necessary to enable connection of spare shift-register stages and spare buffer devices on one side of the connection devices to circuitry on the opposite side.U

## Claims

1. A matrix display apparatus comprising a multiplicity of pixels, an array of row and column address conductors which are insulated from each other and which are electrically coupled to ones of the pixels which are spatially associated with places where said row and column address conductors cross each other, and means for addressing the row and column address conductors to enable selective application to the pixels of respective signals representative of an image to be presented by the apparatus, characterized in that the means for addressing the row and column address conductors comprises, at least for a plurality of said address conductors:
a. an addressing circuit comprising a shift register including a plurality of stages having outputs coupled to respective ones of said address conductors;
b. first and second reparative conductors crossing predetermined ones of said plurality of address conductors;
c. at least one spare shift-register stage; and
d. connection means for electrically connecting an input of the at least one spare shift-register stage, via the first reparative conductor, to an output of a selected one of the stages in the shift register, and for electrically connecting an output of the at least one spare shift-register stage, via the second reparative conductor, to an input of a different selected one of the stages in the shift register.

2. A matrix display apparatus as in claim 1 where the means for addressing the row and column address conductors includes:
a. a plurality of buffer devices through which the stages of the shift register are coupled to the respective address conductors;
b. third and fourth reparative conductors crossing predetermined ones of said plurality of address conductors;
c. at least one spare buffer device; and
d. connection means for electrically connecting an input of the at least one spare buffer device, via the third reparative conductor, to an output of a selected one of the stages in the shift register, and for electrically connecting an output of the at least one spare buffer device, via the fourth reparative conductor, to a selected one of the address conductors.

3. A matrix display apparatus as in claim 1 or 2 including openable connection means for selectively disconnecting the outputs of predetermined ones of the stages in the shift register from inputs of successive stages in the shift register.
